# EUROPEAN PATENT APPLICATION

(11) **EP 3 035 781 A1**
(43) Date of publication of application: **22.06.2016**
(21) Application number: 14290407.7
(22) Date of filing: 18.12.2014
(51) Int. Cl.: H05K 7/14

(54) **Angled Latch**

(71) Applicant: Alcatel Lucent, 92100 Boulogne-Billancourt (FR)
(72) Inventor: Seitz, Reinhold, 90411 Nuernberg (DE); Stiller, Diethard, 90411 Nuernberg (DE)
(74) Representative: Reichl, Wolfgang

(57) **Abstract**

The present document describes a latch 1 which may comprise a base member 2 with a base plate 2a, a lever 3 which may be pivotally arranged on said base member 2. Further, on one side said lever 3 may have a pawl 4 that may be configured to engage with a keeper 101 upon rotation of the lever 3. The latch may further have a locking member 5 for locking said lever 3 and said base member 2 in a closed position of said latch (1), wherein said lever 3 may have a handling portion 8 which may project at an angle α of more than 10° and less than 90° from said base member 2 in said closed position of said latch 1, wherein said angle α may be arranged between a plane of the base plate 2a and a longitudinal axis of the handling portion 8.

## Description

The present document relates to latches and levers. In particular, the present document describes an angled latch. The latches and levers of the present document especially relate to injector/ejector latches which may be used for securing and releasing objects In enclosures. The objects may be printed circuit boards (PC boards), circuit cards, opto-electronic modules, circuit packs and the like. The objects may be held in enclosures such as card cages, cabinets, connector slots, sub-racks, racks, trays and the like. More specifically, the herein described (self-locking inject/eject) latches can be used, e.g., as a mechanical aid for insertion/extraction of a corresponding circuit pack Into/from a respective slot in a sub-rack or an equipment cabinet. The herein described latches can also securely hold a circuit pack in the inserted position, e.g., to maintain the corresponding electrical and/or optical connections even when the circuit pack or the equipment cabinet is subject to shock and/or vibrations. Even further, the specific angled latch of the present document at least has the technical advantage that the footprint of the latch at a faceplate of, e.g., a circuit pack is reduced while a sufficient leverage ratio is maintained.

Circuit packs with a high pin count require relatively high forces for insertion and extraction. Consequently, a lever of a latch must be relatively long in order to build up the required forces for insertion and extraction, respectively. However, a long lever increases the footprint of the latch on a faceplate of a circuit pack or the like if the lever is arranged in parallel to the faceplate in a locked position of the latch. This reduces valuable available space at the circuit pack faceplate for input and output ports.

Furthermore, latches exist which have a lever being orthogonally arranged to the faceplate in a locked position of the latch. Latches with orthogonal levers have a reduced footprint on the faceplate; however, these latches do not exhibit a sufficient leverage ratio which is required for circuit packs or the like with a high pin count. Specifically, the orthogonally arranged latches are limited in view of their lever length because long levers could conflict with cables and the like which are placed in front of the faceplate. However, as mentioned above, short lever latches do not provide sufficient leverage ratio and are also not capable of handling larger boards with more weight.

In addition, new systems with high bitrates require latch designs with highly reliable ESD (electrostatic discharge) shielding properties. However, the axis of current latch levers is often too small and the cutouts in the faceplate do not ensure a proper ESD shielding.

Thus, there is a need for a latch which builds up high forces for the extraction and insertion of objects, such as circuit packs, and which, at the same time, has a reduced footprint on a faceplate of said objects.

According to one aspect, a latch is in particular configured for mounting to a faceplate of an object. The object to which the present disclosure refers may have a relatively large surface area compared to its thickness, and electronic components may be arranged at said object. Said object may be inserted into a receiving space or an enclosure that is adapted to hold said object therein, like a cabinet holds a drawer. With the object being held in the enclosure, the faceplate of said object may substantially cover the enclosure or at least the part of the enclosure that is used by the object.

Preferably the object as referred to herein may include printed circuit boards (PC boards), circuit cards, opto-electronic modules, circuit packs and the like. The enclosures may include cabinets, card cages, connector slots, sub-racks, racks, trays and the like.

The herein described latch may be used for relatively easy insertion of said object into the enclosure and subsequent relatively easy extraction of said object there from, The latch can be configured for selectively engaging various portions of a keeper of the enclosure for effecting an injection or an ejection of said object. In other words, the latch can be used, e.g., as a mechanical aid for insertion/extraction of a corresponding object into/from a respective slot in a sub-rack or an equipment cabinet. The herein described latches can also securely hold an object, such as a circuit pack, in an inserted position, e.g., to maintain the corresponding electrical and/or optical connections even when the circuit pack or the equipment cabinet is subject to shock and/or vibrations.

The latch according to an aspect may comprise a base member. The base member may have a base plate. The base member may be configured to be arranged or mounted on a faceplate of an object, such as a circuit pack or the like. The latch may further comprise a lever which may be pivotally arranged on said base member to rotate around a rotational axis. On one side said lever may have a pawl. The pawl may be configured to engage with the keeper of the enclosure upon rotation of the lever.

The latch may further have a locking member that may be slidably arranged at the lever and that may have a locking projection for engaging with a counter-part projection of said base member in a closed position of the latch. Said lever may have a handling portion which may project with an angle of more than 10° and less than 90° from said base member in a closed position of the latch. The angle may be defined between a (first virtual) plane of the base plate of the base member and a longitudinal axis of the handling portion, in the closed position of the latch. The plane of the base plate is typically parallel to a flat lower surface of the base plate with which the base plate may be attached to the object. The handling portion of the lever may essentially extend along its longitudinal axis. In the closed position of the latch, the angle may also be defined between the first virtual plane and a plane being parallel to the longitudinal axis of the handling portion. In other words, the handling portion in the closed position is neither parallel to the base member nor orthogonal thereto. A preferred range of the angle of the handling portion is between 20° and 75°, and a more preferred range of the angle of the handling portion is between 45° and 70°.

Herein, the term "latch" generally refers to a mechanical fastener configured to join together two or more mating objects or surfaces while allowing for frequent or occasional reversible separation of said mating objects or surfaces. A latch is typically movably attached to a first mating object and is configured to reversibly engage/disengage another piece of hardware (referred to as a keeper or strike) fixedly attached to a second mating object. Depending on the intended application, latches may range in complexity from relatively simple one-piece hardware elements to fairly complex multi-part mechanical devices.

The angle of the handling portion of the latch In a closed state of the latch may be measured from a front surface of the faceplate to a longitudinal axis of the handling portion. Alternatively, the angle of the handling portion may be measured from a base plate of the base member to the longitudinal axis of the handling portion in the closed state of the latch. The base plate of the base member may be a substantially flat plate configured to cover up most of cutouts in the faceplate. The base plate may be configured to be arranged parallel to the front surface of the faceplate when the latch is mounted to the faceplate. In other words, a (part of a) lower surface of the base plate may abut on the front surface of the faceplate in the mounted state of the latch. The angle of the handling portion may be chosen such that a footprint of the lever or latch, respectively, at the faceplate (i.e. the projection of the handling portion onto the faceplate) is minimized in order to, e.g., allow a high density of input/output (I/O) ports on the faceplate. At the same time, the angle may be chosen so that the leverage ratio provides high forces for insertion/extraction of objects, such as circuit packs, with a high pin count. The above-described ranges of preferred angles meet these requirements, so that the presently described latch allows combining a reduced footprint with the ability to generate high extraction/insertion forces.

Furthermore, the angle may also be chosen in view of cable management aspects. Specifically, if the handling portion would stick out too much from the faceplate, cables or fibers, which are placed at the front side of the faceplate, could interfere with the handling portion. Even further, the angle may be limited by the opening range that can interfere with adjacent cable troughs that may run horizontally in the upper and lower area of a card cage. Also in regard of these technical requirements, the herein described angled handling portion/latch achieves that the handling portion does not interfere with cable ducts, cables or the like. More specifically, in regard of the cable management, the preferred angle range of the handling portion was found to be optimal in regard reliably avoiding that the handling portion conflicts or interferes with cables or fibers in an opened and closed state, respectively, of the latch. Further, the angle range was found to ensure high insertion/extraction forces while reducing the footprint on the faceplate.

The latch can be in an opened and in a closed position. In the opened position, the lever may be rotated away from the base member. For example, the lever may be rotated within a range of 30° to 40° around a rotation axis. The rotational range of the lever between opened and closed may be larger or smaller than the above-described range. In embodiments, the rotation of the lever may be limited when a lower part of the lever (e.g. the pawl), by pivoting around its rotational axis, abuts against the base member which may serve as a stop for the lever.

Further, the latch can be in a locked state or in an unlocked state. In the unlocked state, the engaging portion and the counter-part engaging portion of the lever and the base member, respectively, do not engage with each other so that the lever may freely rotate around its rotational axis. In the locked state, the engaging portion and the counter-part engaging portion of the lever and the base member, respectively, engage each other so that (the rotation of) the lever is blocked.

The latch may be pivotally arranged by being configured to rotate around a first rotation axis. The first rotation axis may be defined by a pivot pin inserted into a hole in the base member and a matching hole in the lever base.

A portion of the locking member may be inserted into a cavity in the lever or, more specifically, into a cavity in the lever base. The locking member may be configured to slide with respect to the lever (base).

Further, said base member may have an anchoring portion and/or a guide pin. The anchoring portion and/or the guide pin may protrude downwardly from a base plate of the base member. The guide pin may facilitate the mounting of the latch to the faceplate by providing a centering effect when the guide pin is inserted into a hole of the faceplate during the mounting procedure. Furthermore, the guide pin may facilitate the mounting of the faceplate to the enclosure by guiding the faceplate to its intended position in the enclosure. To this end, the guide pin may be inserted in a corresponding guide hole of the enclosure. The anchoring portion is preferably configured to fixedly hold the base member at the object, such as a circuit pack.

Further, said lever may have at least one tooth portion or fang on the end of the lever at which the pawl is not present, i.e. at an opposite end. The tooth portion may project downward from the lever or the lever base, respectively, through a hole in the faceplate into the interior of the circuit pack. Typically two tooth portions offset from the center plane of the lever are provided for symmetry. The size of the hole in the faceplate may be minimized for EMC reasons. The tooth portion may interact with a (micro) switch on the circuit pack or the like when the latch is mounted to the object. The switch may be pressed down by the tooth portion of the mounted latch so that a user may be informed, e.g. by a light, whether the latch is open or closed. The interaction of tooth portion and switch can further be used for a catch open detection because the switch can signal latch activity before the circuit pack is actually extracted. Thus, an automatic power off routine may be triggered to depower the circuit pack prior to extraction. This helps to prevent arching and connector damage.

Further, the handling portion may comprise at least one or a plurality of sub-portions which may slidably engage with each other and/or the handling portion, respectively, so that the length of the handling portion may be enlarged. In other words, the handling portion of may have a movable retractable extension(s) configured to cause a leverage ratio of the latching member to be variable when the extension is pulled out. The leverage ratio may be variable within a preferred range between approximately 3.0 and approximately 8.0.

Further the handling portion may have a support portion configured to hold an extension member. The extension member may be an extension which, e.g., can be clipped or snap-clipped to the support portion. The extension member may be a detachable portion of the handling portion. The advantage of the extension member is that it can be detached from the handling portion as long as the handling portion is not used so that the footprint of the lever is further reduced. As soon as the latch has to be, e.g., opened, the extension member can be attached to the handling portion in order to have a good handling control and a high leverage ratio.

Further, in a cross sectional view, the handling portion may have a flat upper surface and a curved lower surface. The lower part of the handling portion may have a thicker cross section than an upper part of the handling portion. The shape of the handling portion allows that an operator can firmly hold the handling portion so that he can apply high forces to the lever via the handling portion in an ergonomic manner.

Further, the lower surface of the handling portion may have an inwardly curved section with a grooved surface. Further, the upper surface of the handling portion may have a grooved surface. Preferably, an area with a preferably elliptic shape may be arranged within the grooved surface, wherein the area may have a smooth surface and/or depressed surface. The grooved surfaces, as well as the smooth and/or depressed parts/areas of the handling portion further improve that the operator can optimally operate the handling portion/the lever.

Further, the length of the lever may be longer than the length of the base member. The tooth portion of the lever may abut on an end of the base plate in a closed position of the latch and protrude the latch. By this configuration, the footprint of the latch is reduced while the length of the lever can be long enough to support circuit packs which require high insertion/extraction forces.

Further, said base member may have at least one screw hole in said base plate for fixing the base member with said faceplate of an object, such as a PC board, a circuit pack or a module. A screwed connection between the faceplate and the base member allows supporting heavy circuit packs. For supporting cards with large weight, the base member may also be fixed with two screws, so that two screw holes may be provided in the base plate/base member.

Further, said anchoring portion may have a screw hole with a longitudinal axis being arranged in parallel to the base plate. The anchoring portion may have a U-shaped recessed portion. The U-shaped recessed portion may be used to receive a counter-part projection of the circuit board or the like therein. The object may be mounted to the latch by a screw that is screwed in a screw hole of the anchoring portion, for reliably fixing the object and the latch with each other.

Further, the pawl of the lever may have an upper and a lower lip. The lips are divided by a recess. A sidewall of the recess which may be formed by the upper lip may be arranged horizontally in a closed position of the latch, and a sidewall of the recess which may be formed by the lower lip may be upwardly inclined in a closed position of the latch. Further, the upper lip may have a rectangular end portion, and the lower lip may have a curved end portion, and/or the lower lip may be separated into at least two lip portions. The shape of the lips supports the generation of high insertion/extraction forces when the object is inserted into or extracted from the enclosure. The recess and the specifically shaped lips, e.g., engage with a keeper to generate the extraction/insertion forces. The keeper may be a horizontal cross member of the enclosure.

Further, the locking element may be biased by a separate or integral elastic member into a locked position in the closed position of the latch. In the locked position, the locking projection and the counter-part projection may engage with each other. The locking element movement may also be supported by the elasticity of plastic (spring effect).

Further, a (EMC) gasket may be arranged below the latch base member, e.g. around a lower portion of the anchoring portion. The gasket may be made from an electrically conductive material and/or may be compressible. The gasket may be stamped out to have the desired shape. The gasket advantageously seals the latch base against the faceplate so that EMC integrity is reliably guaranteed. Stand offs at the base member may be provided to limit the compression of the gasket when the latch is mounted to the faceplate, e.g. screwed as explained above. The height of the stand offs is typically configured so that the gasket is compressed by 30-50% of its heights. The stand offs prevent that the distance between latch base member and faceplate drops below the standoff height. For example, 4 stand offs arranged in a rectangular manner around the sealed opening in the faceplate may be provided.

Further, the guide pin may be adapted to hold a spring. The material of the spring may be electrically conductive so that the spring ensures that electro static discharge to the enclosure occurs prior to full insertion of the object into the enclosure and electronic contacts via connectors to wiring of the enclosure are made. Preferably, the spring is a spiral spring which is arranged around the outer surface of the guide pin. The spring may advantageously help that electric charges accumulated at the faceplate or the latch are reliably discharged without causing any damages to electronic components arranged on the object (e.g. electronic components mounted on a circuit pack).

A further aspect may comprise a card assembly with a latch according to at least one of the features as set forth above. Further, the card assembly may have a faceplate to which the first latch may be attached, and an object, such as a circuit board or circuit pack, attached to said anchoring portion of the base member, which may inserted into an opening in the faceplate. The opening may be a cutout in the faceplate, i.e. an internal opening in the faceplate, surrounded on all sides, without breaks, by portions of the faceplate. Preferably, the opening is covered by the latch which is made of a conductive material to shield the opening. The assembly may further comprise a second latch attached to the faceplate at an opposite end thereof with respect to the first latch, wherein the second latch may be nominally identical to the first latch.

Further, the assembly may further comprise said gasket which may be inserted between the base member and the faceplate and configured to at least partially cover the opening. Stand offs may be provided at the base member to set a defined distance between base member and faceplate and a limit gasket compression. Further, the latch may be such arranged on the faceplate that the guide pin may be inserted into a hole in the faceplate. The gasket may be configured to at least partially cover said hole. If the gasket covers the opening and the hole of the faceplate, when the latch is mounted thereto, EMC integrity can be ensured.

Further, the pawl of the latch may be configured to engage with a keeper of the enclosure in the closed state of the latch. The lever may be configured to rotate about the rotation axis such that a rotation of the lever in a first direction causes the upper lip to push on the accommodated keeper to generate an extraction force for the object, such as a circuit board. The lever may be further configured such that a rotation of the lever in an opposite second direction causes the lower lip to push on the accommodated keeper to generate an insertion force for the object.

Further preferred aspects and technical advantages of the herein described latch are that the latch is self-locking with the locking member being biased by the elastic member into a locked position. In addition, it is possible to integrate a micro-switch into the lever or the lever base, respectively, so that the above-described tooth portion may not be necessary for activating a switch at the circuit board.

Summarizing, technical advantages of the latch are that it allows building up high card insertion forces and providing high faceplate I/O port density, so that the costs with respect to a system configuration can be reduced. The latch further renders possible an easy handling of heavy circuit packs. The shielding properties in view of EMC are highly reliable.

In the following, embodiments are explained with reference to the attached drawings, wherein:
Figures 1a and 1b show an exemplary latch in a closed and In an opened position, respectively,
Figures 2a through 2d show different view of an exemplary latch,
Figures 3a and 3b show an exemplary engaging of a pawl of a latch with a portion of a keeper,
Figures 4a through 4c show further views of an exemplary latch in different positions (closed and locked, closed and unlocked, open),
Figures 5a through 5e show further views of an exemplary latch in different positions, in particular closed in FIG. 5d and open in FIG. 5e,
Figure 6a and 6b show exemplary handling portions of the latch, including an extension portion (FIG. 6a) and an add-on tool (FIG. 6b), and
Figure 7 shows an exemplary card assembly providing improved front IO capabilities.

References in the specification to a given embodiment indicate that the embodiment described may include a particular feature, structure, or characteristic, but every embodiment may not necessarily include the particular feature, structure, or characteristic.

It should be noted that the description and drawings merely illustrate the principles of the proposed apparatus and assembly. It will thus be appreciated that those skilled in the art will be able to devise various arrangements that, although not explicitly described or shown herein. Furthermore, all examples recited herein are principally intended expressly to be only for pedagogical purposes to aid the reader in understanding the principles of the proposed methods and systems and the concepts contributed by the Inventors to furthering the art, and are to be construed as being without limitation to such specifically recited examples and conditions. Moreover, all statements herein reciting principles, aspects, and embodiments, as well as specific examples thereof, are intended to encompass equivalents thereof.

The more pin count modern circuit packs (boards) have, the more insertion and extraction force is necessary to insert or extract a circuit pack from an equipment rack. This may lead to longer latches, which take away space at the circuit pack faceplate needed for important front I/O with high port density. Furthermore, new systems with high bitrates need latches with improved EMC (electro-magnetic compatibility) shielding properties. Larger circuit packs furthermore need latches that allow also handling of more weight. Current latches are either long to support higher forces but take away valuable faceplate space, or they are orthogonal to the board (e.g. microPCA latch) but with a leverage ratio that does not support higher pin count. Short latches do not provide sufficient leverage ratio and they are also not appropriate to handle boards with more weight. Often the axis of the lever is too small and the cut outs in the faceplate do not guarantee proper EMC shielding.

The present document therefore suggests an angled latch as a combination of a long latch and an orthogonal latch to allow a minimum footprint at the faceplate and a maximum leverage ratio. The suggested latch also reduces faceplate cut-outs that compromise EMC shielding.

The angle of the proposed latch is chosen in a manner to minimize the footprint at the faceplate and to maximize the leverage ratio. The length of the proposed latch is based on considerations regarding cable management aspects at the front side of a system (e.g. fiber bending radius). For example, the angle of the latch may be limited by the opening range that can interfere with adjacent cable troughs that run horizontally in the upper and lower area of the card cage.

For supporting boards with large weight, the latch base may be fixed with two screws. The proposed latch may be self-locking with an inverted slider engagement compared to existing solutions. The integration of a micro-switch is possible, e.g. accomplished via fangs that cross the faceplate and activate a micro-switch on the printed wire board assembly. Slider movement may be supported by elasticity of plastic components that have a spring effect. A faceplate alignment pin may be provided.

Benefits of the proposed latches are to allow for high card insertion forces and high faceplate I/O port density, which reduces CAPEX for customers with respect to a system configuration. Furthermore, easy handling of heavy circuit packs is achieved and EMC shielding can be guaranteed. Details of embodiments of the proposed latches will be explained.in the following.

An object, such as an electronic and/or optical module, a circuit pack, a printed circuit board or the like, held in a larger enclosure, such as an equipment rack or cabinet, often needs to be outfitted with a mechanical aid that enables relatively easy insertion of said object into the enclosure and subsequent relatively easy extraction of said object there from. Said mechanical aid may also be designed to securely hold the object in the inserted position, e.g., to maintain the corresponding electrical and/or optical connections even when the object or the enclosure is subject to shock and/or vibration.

Various embodiments of an (inject/eject) latch disclosed herein can be used as the above-described mechanical aid. More specifically, an example (inject/eject) latch of the disclosure can be mounted on a faceplate or front panel of a corresponding object such that a handling portion of the latch can be pivoted to cause a pawl of the latch to engage or disengage a keeper. The pawl or jaw may be shaped such that (i) pivoting the handling portion in one direction generates an insertion force that pushes the object into the enclosure and (ii) pivoting the handling portion in the opposite direction generates an extraction force that pulls the object out of the enclosure. When the pawl and keeper are mutually engaged, the object is securely fastened to the enclosure. In some embodiments, the keeper may comprise a cross-member attached to a frame of the enclosure.

In addition to the above-indicated Inject/eject and fastening functions, some latch embodiments disclosed herein may have one or more of the following features/characteristics: (i) a relatively large leverage ratio; (ii) a relatively small footprint on the faceplate or front panel of the corresponding object; and/or (iii) enhanced electromagnetic-compatibility (EMC) characteristics or enhanced (electrostatic discharge) ESD characteristics, respectively. The relatively large leverage ratio may address a need for the generation of relatively large insertion and extraction forces that may be necessary in the process of handling a circuit pack with a relatively high pin count at the backplane. Such circuit packs become more and more prevalent, e.g., in contemporary communication systems. The relatively small footprint of the latch on the faceplate or front panel may address a need for making most of the surface area on the faceplate or front panel available for elements of an input/output (I/O) interface, which tends to have a relatively high I/O port density in contemporary communication systems.

Enhanced ESD and EMC characteristics may address a need for improved electromagnetic shielding properties, e.g., to support substantially interference-free operation of various electronic circuits configured to operate at a relatively high bit rate or clock frequency.

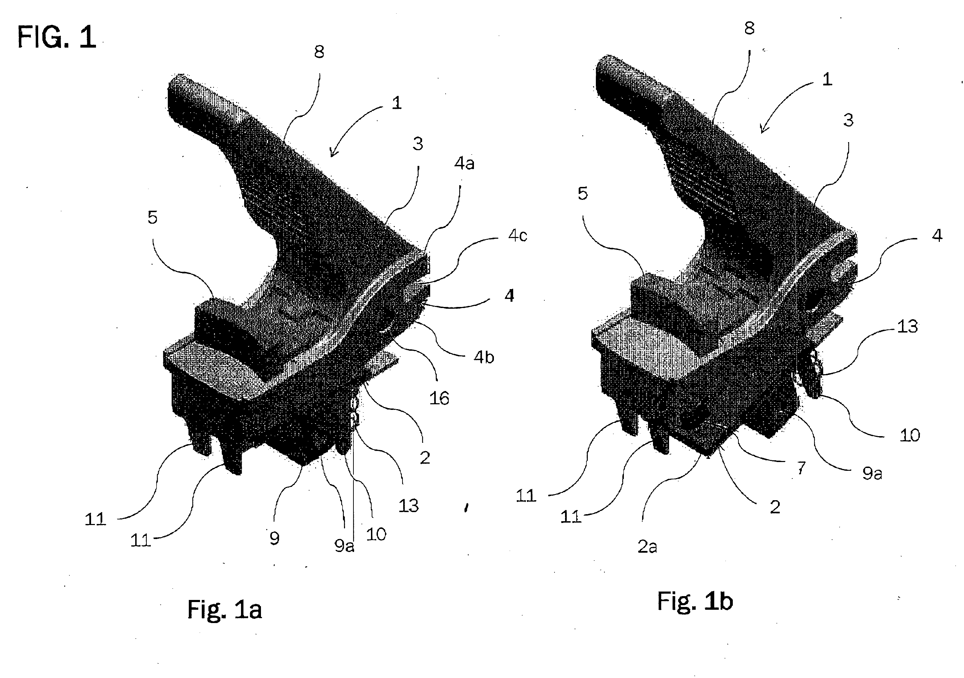

FIGs. 1a-1b show three-dimensional perspective views of a latch 1 according to an embodiment of the disclosure. FIG. 1a shows the latch 1 in a closed and locked position/state. FIG. 1b shows an opened position of the latch 1, where a lever 3 is rotated away from a base member 2.

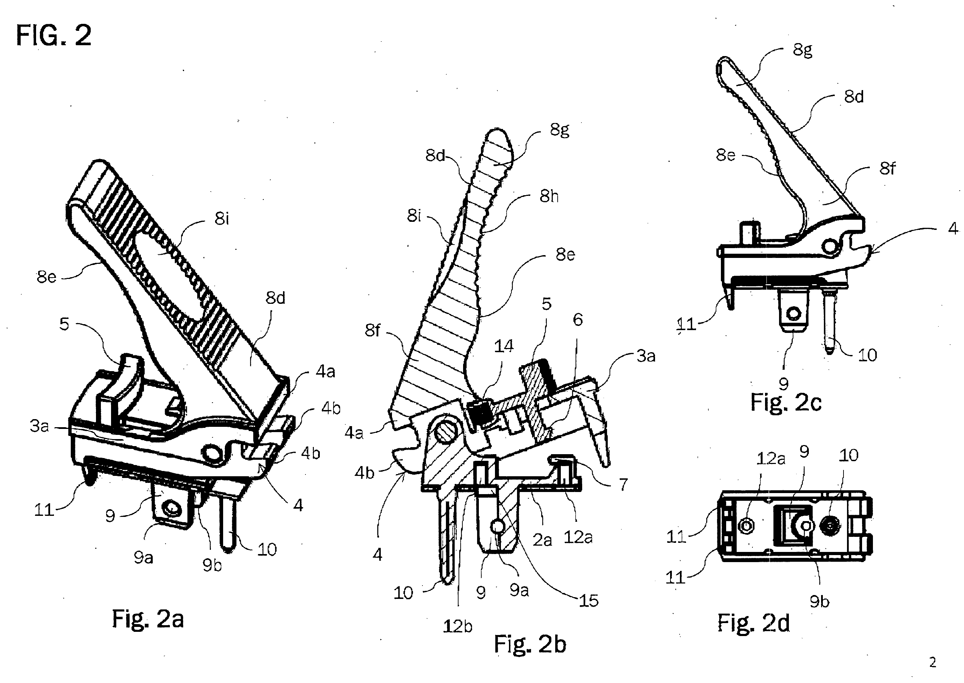

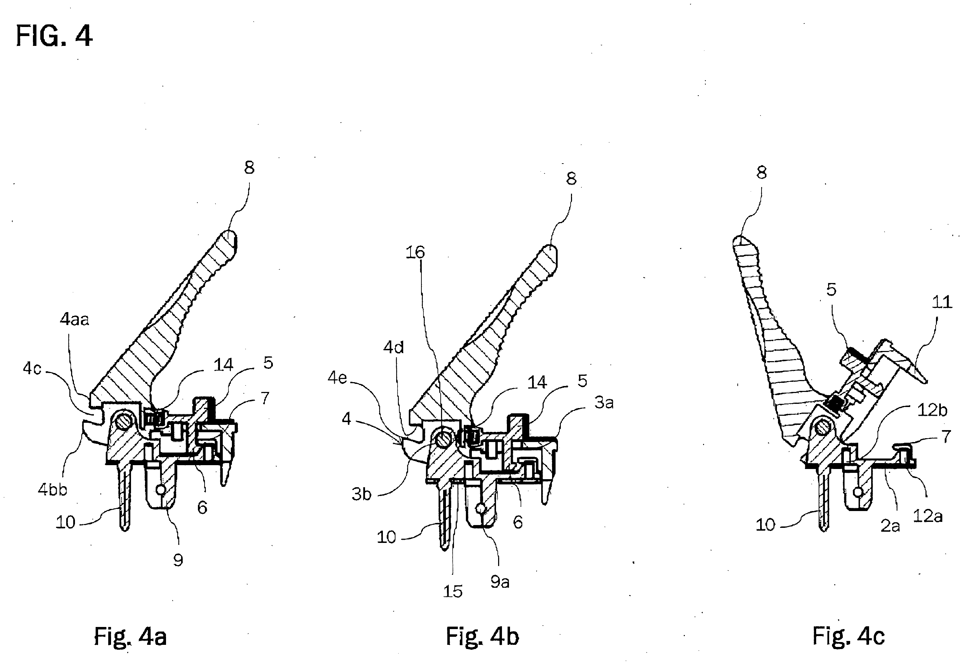

The latch 1 comprises said lever 3 that is rotatable coupled to said base member 2 using a pivot pin 16. The lever 3 has a handling portion (or handle) 8 that can be used to pivot the lever 3 about a rotation axis defined by the pivot pin 16. Said pivoting can be used to change the relative orientation of the lever 3 and the base member 2, e.g., as indicated in FIGs. 2a, 2b and 4a to 4c.

A distal end of the handling portion 8 has a textured or grooved surface whose contoured profile serves to reduce the occurrence of slippage of the operator's hand in the process of gripping the handle and turning it around the pivot pin 16. In the embodiment shown for example in FIGs. 2a to 2c, the grooved surface has a plurality of relatively shallow grooves that are approximately perpendicular to the longer side of handling portion 8. In alternative embodiments, other suitable contoured profiles can similarly be used to form the grooved surface.

The cross sectional view of FIGs. 2b and 2c as well as the perspective view of FIG. 2a depicts further details of a preferred shape of said handling portion 8. The handling portion 8 has a flat upper surface 8d and a curved lower surface 8e. A lower part 8f of the handling portion 8 may have a thicker cross section than an upper part 8g of the handling portion 8. The shape of the handling portion 8 allows that an operator can firmly hold the handling portion so that he can apply high forces to the lever via the handling portion 8 in an ergonomic manner.

Further, FIGs. 2a to 2c show that said lower surface 8e of the handling portion 8 has an inwardly curved section 8h with a grooved surface. Further, said upper surface of the handling portion 8 has a grooved surface. Preferably, an area with a preferably elliptic shape 8i is arranged within the grooved surface, wherein the area 8i has a smooth surface and/or depressed surface. The grooved surfaces, as well as the smooth and/or depressed parts/areas 8i of the handling portion 8 further improve that the operator can optimally operate the handling portion8/the lever 3.

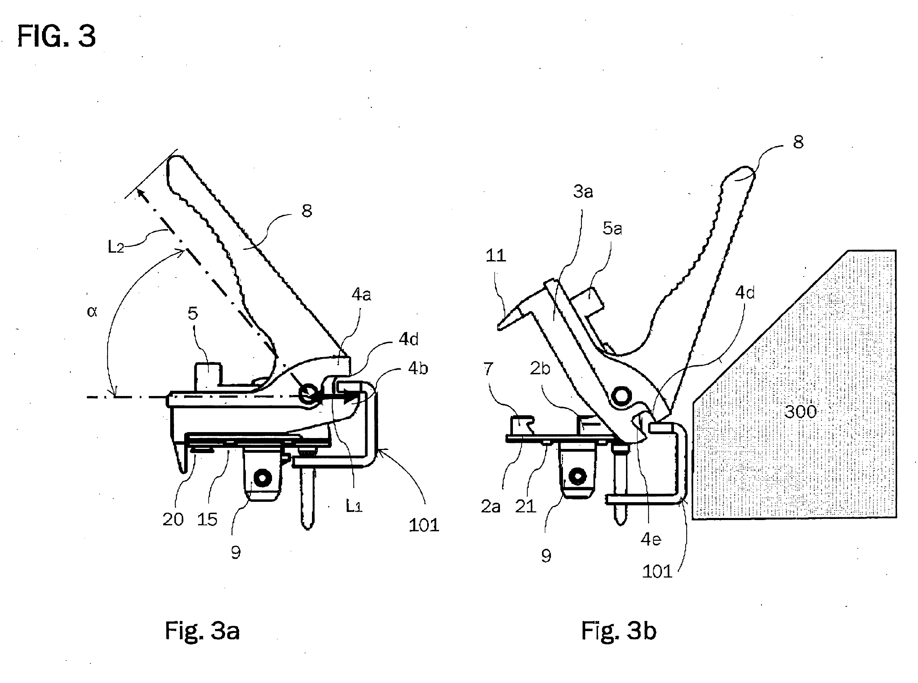

The lever 3 further has a pawl 4 having an upper lip 4a and a split or separated lower lip 4b. A recess 4c between the lips 4a, 4b is shaped to engage with a corresponding keeper 101, e.g., as indicated in FIG. 3. Two lip portions of the separated lower lip 4b enable proper coupling between the lever 3 and the base member 2 by accepting a holed protrusion 2b (partially visible in FIG. 3b) of the base member in the manner that enables proper insertion of the pivot pin 16 into a lever base 3a and the base member 2 when the hole (not shown) in the protrusion 2b is aligned with the corresponding holes 3b in the lever 3 or lever base 3a, respectively.

The handling portion 8 may be partially hollow and shaped to accommodate a locking member 5. The locking member 5 is configured to lock the latch 1, e.g., when the pawl 4 engages with a corresponding keeper 101, which may be part of a cross-member of a sub-rack (not shown). That means that the locking member 5 together with a hook 6 can be used to bring the latch 1 into a locked state.

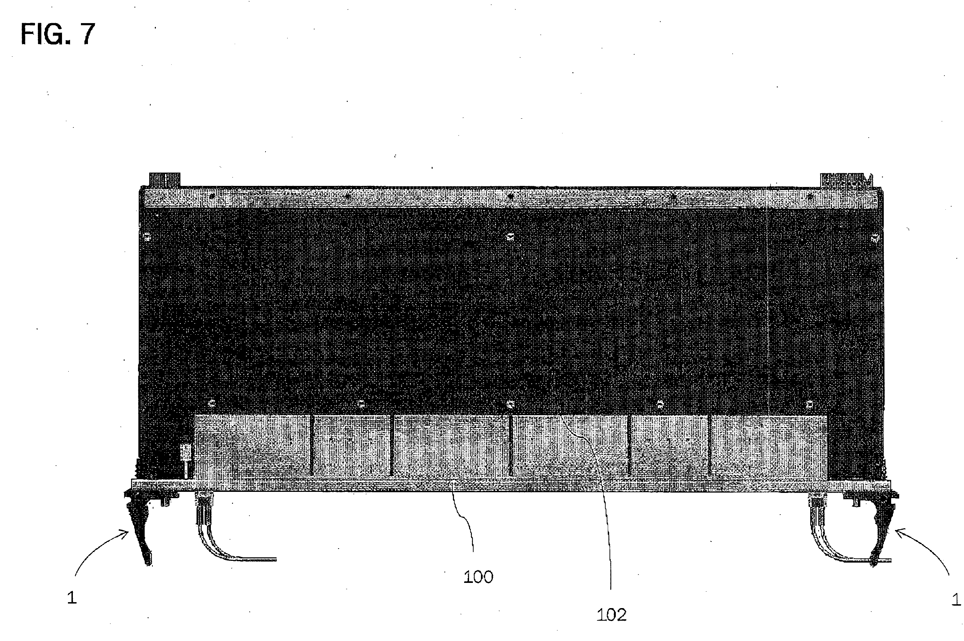

The base member 2 further has a guide pin 10 that can be used to guide the faceplate and the attached object 102, such as a module, circuit pack, or drawer to which the latch 1 is attached, into a proper alignment position within the corresponding slot of the enclosure. For example, in embodiments having an EMV gasket arranged laterally at the faceplate to close and shield openings between adjacent faceplates arranged in the enclosure or between a faceplate and the enclosure, lateral forces might be generated during the insertion or extraction process that can move the faceplate 100 (see FIG. 7) to which the latch 1 is attached away from its intended position. The guide pin 10 may therefore be useful to absorb such lateral forces and mitigate undesired effects of such lateral forces, thereby facilitating proper positioning and insertion of the object in the enclosure. In some embodiments, the guide pin 10 can be detachable from the base member 2, e.g., by means of a threaded stub that can be screwed into a matching threaded hole (neither of which is explicitly shown). In some embodiments, the guide pin 10 can be absent altogether.

The base member 2 further includes said above-mentioned anchoring portion 9 that can be used, e.g., to mount a circuit board of the corresponding module, circuit pack, or drawer. The anchoring portion 9 has a hole or a screw hole 9a. For example, both guide pin 10 and anchoring portion 9 can be inserted into respective cutouts in the faceplate 100 of the corresponding module, circuit pack, or drawer such that (i) a foot portion of the base member 2 is substantially flush with the outer surface of the faceplate 100 and (ii) the guide pin 10 and anchoring portion 9 protrude, through the cutouts in the faceplate 100, into the interior portion of the module, circuit pack, or drawer. The corresponding circuit board can be attached to the anchoring portion 9, e.g., using a screw inserted into the screw hole 9a therein. The mounted latch 1 is shown in FIG. 7. Further, the anchoring portion 9 can have a cutout, e.g. a U-shaped recessed portion 9b, in order to engage with a projection - of the circuit board or the like therein, which can be screwed together via the screw hole 9a.

In an example embodiment, the base plate 2a of the base member 2 is a substantially flat plate (see e.g. FIGs. 2a to 2d) configured to cover up most of the cutouts in the faceplate 100 (see e.g. FIG. 7). When the base member 2 is made of an electrically conducting material (e.g., metal), this configuration of the base plate 2a serves to effectively block off the external electromagnetic radiation that would otherwise penetrate through the cutouts into the interior portion of the module, circuit pack, or drawer and possibly interfere with the operation of the electronic circuits therein. Also, the electromagnetic radiation generated in the interior portion of the module, circuit pack, or drawer can be blocked from escaping to the exterior. The electromagnetic shielding provided by the base plate 2a and an optional EMC gasket may therefore be used to improve and/or enhance the EMC/ESD characteristics of the corresponding module or drawer.

The above-mentioned pivot pin 16 is substantially cylindrical in shape, but may have at least one slightly thicker portion along its longitudinal axis. The thicker portion may also be knurled. The diameter of the thinner portion (not shown) is selected such that the pivot pin 16 can be inserted with play into said hole of the protrusion 2b of base member 2 and a hole on side of the lever 3. The pivot pin 16 is fixed on the other side of the holes 3b of the lever 3 and rotates in the hole of the protrusion 2b.

FIGs. 3a and 3b show closed/locked and open states/positions of the latch 1 according to an embodiment of the disclosure. More specifically, FIG. 3a shows a side view of the latch 1 with the pawl 4 being engaged with a keeper 101. FIG. 3b shows a side view of latch 1 with pawl 4 being disengaged from keeper 101 and partially extracted there from. In the embodiment shown in FIGs. 3a and 3b, the keeper 101 comprises a bracket having a relatively short front wall and a relatively tall back wall. The back wall has a hole in it, into which the guide pin 10 can be inserted, e.g., as indicated in FIGs. 3a and 3b, to guide the circuit pack to which the latch 1 is attached during circuit-pack injection into or ejection from the corresponding enclosure. In the closed state of the latch 1, said recess 4c of the pawl 4 engages with the front wall of the keeper 101. To transition from the closed state to the open state, the handling portion 8 is rotated about the pivot pin 16 by approximately 40° in the clockwise direction. During this rotation, the pawl's upper lip 4a is pressed against the outer surface of the front wall of the keeper 101, thereby generating an extraction force. To transition from the open state to the closed state, the handling portion 8 is rotated about the pivot pin 16 in the counterclockwise direction. During this rotation, the pawl's lower lip 4b is pressed against the inner surface of front wall of the keeper 101, thereby generating an insertion force.

Furthermore, FIGs, 2 and 3 illustrate an exemplary specific shape of the pawl's lips 4a, 4b. Specifically, a sidewall 4d of the recess 4c which is formed by the upper lip 4a is arranged horizontally in a closed position of the latch 3 (see e.g. FIG. 3a), and a sidewall 4e of the recess 4c which is formed by the lower lip 4b is upwardly inclined in a closed position of the latch 1 (see e.g. FIG. 3a).

Further preferably, the upper lip 4a has a rectangular end portion 4aa, and the lower lip 4b has a curved pointed end portion 4bb. The lower lip 4b is separated so that at least two lip portions of the lower lip 4b are present (see e.g. FIG. 2d). The above-described shape of the lips 4a, 4b further improves that the extraction/insertion forces are exactly directed to the part of the keeper 101, at which they are most effective. The lower lip 4b may stick out further than the upper lip 4a so that the pawl 4 can be easily inserted or engaged with the keeper 101.

The magnitude of the extraction and insertion forces generated by the rotation of the handling portion 8 depends on the leverage ratio, R, of the lever. More specifically, the leverage ratio R can be defined as the ratio of the length (L2) of the handling portion 8 and the length (L1) of the pawl, i.e., R = L2/L1. Both lengths L1 and L2 are Indicated in FIGs. 3a, 3b by respective dashed lines.

In the above-described embodiments of the latch 1, a leverage ratio R is approximately 3.6. This leverage ratio enables latches 1 to generate and withstand without breaking (i) an Insertion force of up to about 600 N per circuit pack or 300 N per individual latch 1 and (ii) an extraction force of up to about 300 N per circuit pack or 150 N per individual latch.

A gasket 15 is inserted between base plate 2a and faceplate 100. A screw 20 is shown that has been screwed into screw hole 12a to fix latch 1 and faceplate 100. The gasket is compressed about 30-50% by the pressure exerted by the screwing connection. In order to limit compression and define a distance between base plate 2a and faceplate 100, stand offs 21 (shown in FIG. 3b) protrude from the base plate 2a.

FIG. 3b furthermore shows one of the benefits of the angled handling portion 8 of the latch 1 according to a herein described example. The handling portion 9 of the exemplary latch 1, depicted in FIGs. 3a and 3b, has an angle between a plane of the base plate 2a and a longitudinal axis of the handling portion 8 of about 50°. The angle is marked with "α" in FIG. 3a. In other words, in the closed position of the latch, the angle α may be measured/positioned between a first (virtual) plane and second (virtual) plane. The first virtual plane may cut the rotational axis of the lever 3 and may be arranged in parallel to the base plate 2a. More specifically, the first virtual plane may cut the rotational axis of the lever 3 and may be arranged in parallel to a lower surface of the base plate 2a. Said lower surface may abut with the front surface of the faceplate in the mounted state of the latch. The second virtual plane may be aligned with a longitudinal axis of the handling portion 8. The second virtual plane may also be arranged in parallel to a longitudinal axis of the handling portion 8 and may cut the rotational axis of the lever 3. The two broken lines of Fig. 3a, which are marked with L1 and L2, display virtual side views of the first and second virtual planes in the closed position of the latch.

Furthermore, the angle α may also be defined by an angle β, which may arranged between a third virtual plane and the second virtual plane in the closed position of the latch. The third virtual plane may be vertically arranged and may cut the rotational axis of the lever 3 in the closed position of the latch. The angle α may be calculated by the equation: α = 90 °- β.

Providing the handling portion 8 having an angle of about 50° to the base plate 2a, the opened latch 1 does not interfere with cable ducts or fiber troughs, as e.g. indicated by the grey block 300 in FIG. 3b. More specifically, even in the opened position of the latch 1, the lever 3 and the cable duct or fiber trough do not contact each other, but have a relatively large space in their between so that an operator is still able to place cables or carry out other installation work. With, e.g., an orthogonal latch from the state of the art, the lever 3 might interfere with the cable duct or the like which renders necessary installation works cumbersome.

FIGs. 4a to 4c show different possible states and/or positions of the latch 1. FIG. 4a shows a closed and locked state of the latch 1. An engaging portion 6 of the locking member 5 is in contact with a counter-part engaging portion 7 of the base member 2. The engaging portion 6 is an integral part of the locking member 5 which is slidably arranged within the lever base 3a. A distal end of the engaging portion 6 has a hooked shaped which can engage with a hooked part of a distal end of the counter-part engaging portion 7. The counter-part engaging portion 7 protrudes from the base plate 2a. Preferably, the counter-part engaging portion 7 houses a screw hole 12a.

By integrating the screw hole 12a into the counter-part engaging portion 7 of the base member 2, the available space at the base member 2 is used in an optimal manner so that the base member 2 can be reduced in view of its size or volume. This further reduces the footprint of the latch. The screw hole 12a is used for fixing the base plate 2a reliably by a screwing connection to the faceplate 100 of an object 102. A second screw hole 12b is used for increasing the reliability of the connection between the faceplate 100 and the base plate 2a in case that heavy objects 102 are mounted.

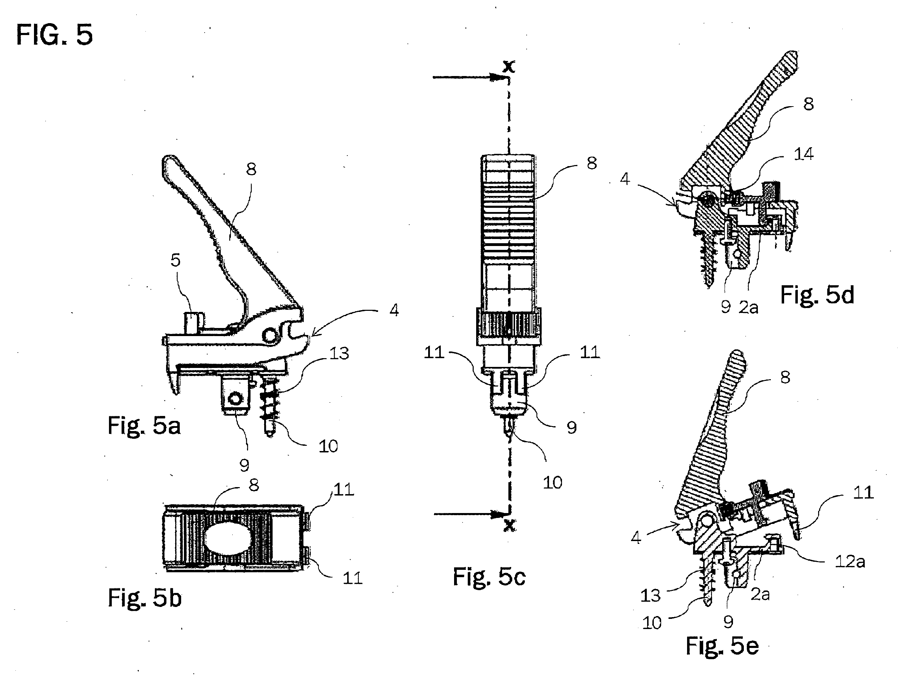

FIG. 4b further shows that the latch 1 is still closed, but the locking member 5 is now unlocked. The unlocking has been achieved by pressing the locking member 5 against the force of an elastic member 14 which holds the locking member 5 in a locked position. A protruding section of the locking member 5 can be used by the operator to more ergonomically press the locking member 5 to the unlocked position (against the elastic member 14). FIGs. 4a to 4c include an illustration of an exemplary fixing of the elastic member 14 which is held by a bifurcated (in the cross-sectional view) distal end of the locking member 5. On the other side, the elastic member 14, which may be a spiral spring or a rubber member, abuts against a flat portion of the lever 3. In the position as shown in FIG. 4c, the latch 1 is open(ed). The opening has been achieved by rotating the lever 3 about the pivot pin 16 which is also shown by FIG. 5e.

Furthermore, FIG. 4b, e.g., shows a gasket 15 that can be used in the latch 1 according to an embodiment of the disclosure. In an example embodiment, the gasket 15 is made of an electrically conducting material, such as fabric over foam, metal, or metallic alloy. As such, the gasket 15 can be used to improve EMC characteristics of the latch 1. In some embodiments, both the gasket 15 and the base member 2 can be made of electrically conducting materials.

The gasket 15 may contact an outer surface of the faceplate 100 and may cover a significant portion of holes and openings of the faceplate 100 which are not illustrated in FIG. 7, to inhibit penetration of external and internal electromagnetic radiation through these faceplate cutouts, thereby improving the shielding characteristics of the faceplate.

FIGs. 5a to 5e include illustrations of an exemplary latch 1 with a side view in FIG. 5a, a top view in FIG. 5b, a front view in FIG. 5c and cross-sectional views along the line X-X in FIGs. 5d and 5e. Further, FIGs. 5d and 5e show a closed and locked state of the latch 1 as well as an opened state of the latch 1, respectively. In addition to the above-described features, FIG. 5a inter alia depicts the latch 1 having a spring 13 mounted to the guide pin 10. The spring 13 supports electrostatic discharge prior to circuit pack insertion, in particular, in case the spring 13 is made from a conductive material such as metal.

FIG. 5c further provides a view on the tooth portion(s) 11 of the latch 1. The tooth portions 11 (or fangs) can be inserted into respective holes in the faceplate 100 in order to push a (micro) switch on the circuit pack. The switch can be used to indicate the state of the latch 1, i.e. whether the latch 1 is open or closed. This information can be used, e.g., prior to circuit pack removal to shut down electronic components of the circuit pack. For example, when an opening movement of the latch 1 is detected by the fangs disengaging the switch, power supply to the circuit pack can be disabled to avoid any damage by subsequent circuit pack removal and electrical discontinuation of circuit pack connections with the rack or card cage.

FIGs. 5d and 5e moreover exemplarily show a screw inserted into the screw hole 12b for holding the faceplate 100 and the latch 1 safely together. The closed position of the latch 1 in FIG. 5d also shows that the tooth portions 11 abut or at least closely position next to the distal end of the base plate 2a when the latch 1 is closed so that the latch 1 can be very compact and can have a minimized footprint of the faceplate 100.

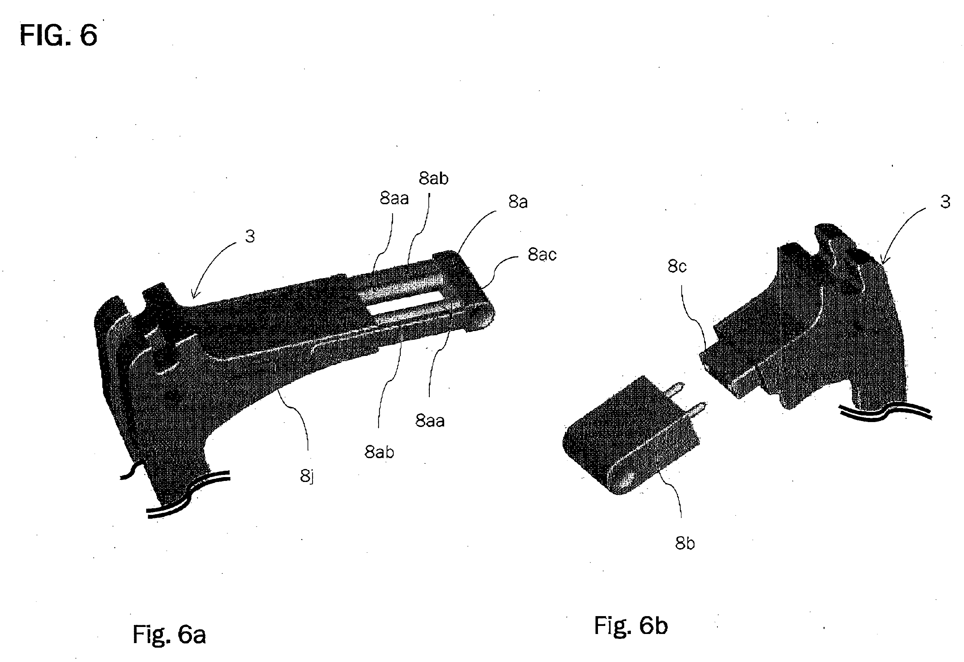

FIG. 6a shows a three-dimensional perspective view of a lever 3 that can be used according to an alternative embodiment of the disclosure. The lever 3 is generally similar to the lever 3 of e.g. FIG. 1, except that the handling portion 8 has a movable retractable extension or sub-portion 8a. The retractable extension 8a comprises side rails 8ab and cylindrical rods 8aa joined together by a connecting bar 8ac, e.g., as indicated in FIG. 6a. The remaining part of the handling portion 8 has side-grooves 8j. The side-grooves 8j are configured to accommodate said side rails 8ab to guide the side rails 8ab when the retractable extension 8a is moved. The cylindrical rods 8aa are configured to fit into corresponding holes in the (remaining part of the) handling portion 8 and have a sufficiently large diameter to withstand and transfer to the handling portion 8 torque that may be applied to the lever 3 during insertion/extraction of the corresponding circuit pack. In the fully extended state, the latch 1 may have an increased leverage ratio R of, e.g., 7.5.

FIG. 6b shows a three-dimensional perspective view of a lever 3 according to another alternative embodiment of the disclosure. The lever 3 is generally similar to the lever of FIG. 1, except that it has a detachable end portion or extension member 8b which can be held by a support portion 8c of the handling portion 8. The detachment may provide one or both of the following benefits: (i) reduce the probability of the latch 1 unlocking when (the shortened) handling portion 8 is accidentally pushed or bumped and (ii) reduce the possible interference of the latch 1 with the cable connections at the faceplate 100 of the corresponding circuit pack.

FIG. 7 illustrates a faceplate 100 of a circuit pack 102 having two latches 1 attached thereto according to an embodiment of the disclosure. Referring to FIG. 7, the two latches 1 are nominally identical to one another, e.g., with each being a separate instance (copy) of the latch shown in FIG. 1. The use of the same latch 1 model at the upper and lower ends of faceplate 100 may be enabled by the fact that the structure of the latch 1 (in the assembled form) is symmetric with respect to a central longitudinal plane marked with X-X in FIG. 5c. A symmetric latch can be flipped and applied to the other side of the faceplate. Latch components that are symmetrically arranged off the central longitudinal plane, like the fangs 11, are still on the right side of the latch 1 to interact with the circuit pack, e.g. to activate switches that are arranged on one side of the circuit pack.

In an example embodiment, cutouts in the faceplate 100 include a round hole and an opening (not explicitly shown). The round hole has a diameter that enables insertion of the guide pin 10 into this hole. The round hole has a position is aligned with a blind screw hole 12a and/or 12b (see e.g. FIG. 2b) in the base plate 2a of the base member 2. In an example embodiment, the screw holes 12a, b are used to attach the latch 1 to the faceplate 100, e.g., by using a screw. The opening of the faceplate 100 has a shape that enables insertion of the anchoring portion 9.

After the latch 1 is attached to the faceplate 100, the base plate 2a may substantially fully cover the holes and openings of the faceplate 100. When the base member 2 is made of an electrically conducting material, the base plate 2a inhibits penetration of external electromagnetic radiation through the cutouts in the faceplate 100. This shielding effect of the latch 1 with respect to the holes and opening may advantageously enable the circuit pack and the faceplate 100 to have improved EMC characteristics compared to those achievable with functionally comparable prior-art latches.

Various embodiments of the latches 1, faceplates 100, and circuit packs 102 disclosed herein may include features that make these devices at least partially compatible with the following standards: (i) CompactPCI; (ii) Advanced Telecom Computing Architecture, ATCA; (iii) IEC 60917; and (iv) IEC 60297.

Various embodiments of the latches 1 disclosed herein may provide one or more of the following benefits:
(i) the latch footprint on the faceplate 100 can be minimized while the leverage ratio R can be relatively large and/or adjustable, due to, e.g., the handling portion 8 being angled;
(ii) installation work, such as wiring work and the like, can be less cumbersome, at least due to the angled handling portion 8;
(iii) handling of the latch is more ergonomic and allows to generate high extraction/insertion forces due to, e.g., the specific shape of the handling portion 8;
(iv) variable leverage ratio R, e.g., implemented by using a telescopic extension of the handling portion 8 or an add-on tool;
(v) a self-locking feature;
(vi) enhanced EMC shielding, e.g., with an electrically conducting base member 2, the use of an EMC gasket 15 and/or the use of a spring 13 at the guide pin 10;
(vii) the latch 1 as described herein requires only relatively small cutouts in the faceplate 100;
(viii) flexible material selection (wherein the latch 1 can be implemented, e.g., as a die cast part) to make the latch 1 more robust and suitable for higher insertion/extraction forces;
(ix) variable latch 1 placement on the faceplate 100, e.g., to accommodate various card positions, which may depend on the printed-wire-board thickness and the selected card slot in a sub-rack; and
(x) relatively easy assembly of the constituent parts of the latch 1, because, for example, the pivot pin 16 may be designed as a snapin axis.

It should be noted that the description and drawings merely illustrate the principles of the proposed methods and systems. Those skilled in the art will be able to implement various arrangements that, although not explicitly described or shown herein, embody the principles of the invention and are included within its spirit and scope. Furthermore, all examples and embodiment outlined in the present document are principally intended expressly to be only for explanatory purposes to help the reader in understanding the principles of the proposed methods and systems. Furthermore, all statements herein providing principles, aspects, and embodiments of the invention, as well as specific examples thereof, are intended to encompass equivalents thereof.

## Claims

1. A latch comprising:
- a base member (2) with a base plate (2a),
- a lever (3) which is pivotally arranged on said base member (2), wherein on one side said lever (3) has a pawl (4) that is configured to engage with a keeper of an enclosure upon rotation of the lever (3),
- a locking member (5) for locking said lever (3) and said base member (2) in a closed position of said latch (1), wherein
said lever (3) has a handling portion (8) which projects at an angle (α) of more than 10° and less than 90° from said base member (2) in said closed position of said latch (1), wherein said angle (α) is arranged between a plane of said base plate (2a) and a longitudinal axis of the handling portion (8).

2. The latch according to claim 1, wherein said locking member (5) is slidably arranged at said lever (3) and has a locking projection (6) for engaging with a counter-part projection (7) of said base member (2) in said closed position of said latch (1).

3. The latch according to one of the previous claims, wherein said lever (3) comprises at least one extraction portion (8a) which slidably engages with said handling portion (8) so that the length of the handling portion (8) is adjustable and/or wherein the handling portion (8) has a support portion (8c) configured to hold an extension member (8b).

4. The latch according to one of the previous claims, wherein, in a cross sectional view, the handling portion (8) has a flat upper surface (8d) and a curved lower surface (8e), and a lower part of the handling portion (8f) has a thicker cross section than an upper part of the handling portion (8g).

5. The latch according to claim 4, wherein a lower surface (8e) of the handling portion (8) has an inwardly curved section (8h) with a grooved surface and/or an upper surface (8d) of the handling portion (8) has a grooved surface, wherein an area with an elliptic shape (8i) that is arranged within the grooved surface has a smooth surface.

6. The latch according to one of the previous claims, wherein a length of the lever (3) is longer than the length of the base member (2), and a tooth portion (11) of the lever (3) abuts on an end of the base plate (2a) in a closed position of the latch (1).

7. The latch according to one of the previous claims, wherein said base member (2) has at least one screw hole (12a,b) in the base plate (2a) for fixing the base member (2) with a faceplate of an object.

8. The latch according to one of the previous claims, wherein the pawl (4) of the lever (3) has an upper and a lower lip (4a, 4b) which are divided by a recess (4c), wherein a sidewall (4d) of the recess (4c) which is formed by the upper lip (4a) is arranged horizontally in said closed position of the latch (3), and a sidewall (4e) of the recess (4c) which is formed by the lower lip (4b) is upwardly inclined in said closed position of the latch (1),

9. The latch according to claim 8, wherein the upper lip (4a) has a rectangular end portion (4aa), and the lower lip (4b) has a curved end portion (4bb), and/or the lower lip is separated into at least two lip portions.

10. The latch according to one of the previous claims, wherein the locking member (5) is biased by an elastic member (14) into a locked position in said closed position of the latch (1), and wherein in the locked position the locking projection (6) and the counter-part projection (7) engage with each other.

11. The latch according to one of the previous claims, wherein a gasket (15) is arranged at the base member (2), in particular around a lower portion of an anchoring portion (9) of the base member (2), the gasket (15) is made from an electrically conductive material, and/or
a guide pin (10) is adapted to hold a spring (13), and the material of the spring (13) is electrically conductive.

12. An assembly comprising:
- a first latch (1) according to at least one of the previous claims,
- a faceplate (100) to which the first latch (1) is attached; and
- an object (102), such as a circuit board or a circuit pack, attached to an anchoring portion (9) of the base member (2), the anchoring portion (9) being inserted into an opening in the faceplate (100).

13. The assembly of claim 12, further comprising:
- a second latch (1) according to one of the claims 1 to 11 attached to the faceplate (100) at an opposite end thereof with respect to the first latch (1), wherein the second latch (1) is nominally identical to the first latch (1).

14. The assembly according to one of claims 12 or 13, further comprising
a gasket (15) which is inserted between the base member (2) and the faceplate (100) and configured to at least partially cover the opening, and/or
a guide pin (10) arranged at the latch (1) so as to protrude through a hole in the faceplate (100), the gasket (15) further configured to at least partially cover said hole.

15. The assembly according to one of claims 12 to 14, wherein the pawl (4) of the latch (1) is configured to engage with the keeper (101) in the closed state of the latch (1), wherein
said recess (4c) of the pawl (4) is configured to engage with the keeper (101); and
the lever (3) is configured to rotate about a rotational axis such that (i) a rotation of the lever (3) In a first direction causes the upper lip (4a) to push on the engaged keeper (101) to generate an extraction force for the object (102), and (ii) a rotation of the lever (3) in an opposite second direction causes the lower lip (4b) to push on the engaged keeper (101) to generate an insertion force for the object (102).
